# EUROPEAN PATENT SPECIFICATION

(11) **EP 1 662 556 B1**
(45) Date of publication and mention of the grant of the patent: **06.11.2013**
(21) Application number: 04772141.0
(22) Date of filing: 25.08.2004
(51) Int. Cl.: H01L 21/316, C23C 16/40, C23C 16/448, C23C 16/452

(54) **PROCESS FOR PRODUCING OXIDE THIN FILM**
PROZESS ZUR HERSTELLUNG EINES OXID-DÜNNFILMS
PROCEDE DE FABRICATION D'UN MINCE FILM D'OXYDE

(30) Priority: 25.08.2003 JP 2003300014
(43) Date of publication of application: 31.05.2006
(73) Proprietor: ULVAC, INC., Chigasaki-shi, Kanagawa 253-8543 (JP)
(72) Inventor: NISHIOKA, Yutaka, ULVAC, INC., Susono-shi, Shizuoka 4101231 (JP); KAJINUMA, Masahiko, ULVAC, INC., Susono-shi, Shizuoka 4101231 (JP); YAMADA, Takakazu, ULVAC, INC., Susono-shi, Shizuoka 4101231 (JP); MASUDA, Takeshi, ULVAC, INC., Susono-shi, Shizuoka 4101231 (JP); UEMATSU, Masaki, ULVAC, INC., Susono-shi, Shizuoka 4101231 (JP); SUU, Koukou, ULVAC, INC., Susono-shi, Shizuoka 4101231 (JP)
(74) Representative: AMMANN PATENTANWÄLTE AG BERN
(86) International application number: PCT/JP2004/012180
(87) International publication number: WO 2005/020311

(56) References cited:
- WO-A1-03/006707
- JP-A- 8 083 793
- JP-A- 8 268 797
- JP-A- 11 126 877
- JP-A- 2000 058 525
- JP-A- 2003 086 586
- JP-A- 2003 324 101
- US-A- 5 462 899
- US-A1- 2003 062 554

## Description

### Field of the Invention

The present invention relates to a method for preparing an oxide thin film and more specifically to a method for the preparation of an oxide thin film according to the chemical vapor phase growth technique (CVD).

### Description of the Prior Art

According to US-5,462,899, a silicon dioxide film is deposited by CVD using an organosilicon compound and ozone as principal reactants. The organosilicon is mixed with a gas of low ozone concentration outside the reaction chamber, and a gas of high ozone concentration which reacts more vigorously is admixed in the reaction chamber. The aim is to avoid deposition of reaction products in the pipelines while maintaining the advantages of the premixing method.

WO-A-03/6707 discloses a process for manufacturing an insulating film of a thickness of 20 nm or less by CVD. The deposition is performed in multiple steps, and the reactants are mixed in the gas distribution plate of the CVD reactor.

There have actively been investigated chemical vapor phase growth techniques which are excellent in the film-forming ability even at steps (or excellent in the step coverage) and which permit the mass-production of such a film in order to respond to the recent demand for a high level of integration of semiconductor elements. Among them, when preparing a thin film of, for instance, an oxide of a paraelectric material such as SiO₂, TiO₂, Al₂O₃, Ta₂O₅, MgO, ZrO₂, HfO₂, (Ba, Sr) TiO₂ or SrTiO₃; or an oxide of a ferroelectric material such as Pb (Zr, Ti) O₃, SrBi₂Ta₂O₉ or Bi₄Ti₃O₁₂, oxygen atoms in the resulting film are lost and this leads to the inhibition of any satisfactory epitaxial growth of the film. Accordingly, the insulating property of the resulting film is reduced for the films of oxides of paraelectric materials and oxides of ferroelectric materials.

The reduction of these characteristic properties would be originated from the decomposition processes of organic materials used as raw materials. The decomposition processes of organic materials have not yet been clearly elucidated, but it has been estimated that the organic material by nature is decomposed into several tens of intermediates and stable molecules during its decomposition step. It would be considered that only parts of metal atom-containing molecules among them contribute to the formation of a film. Moreover, characteristic properties of the resulting films differ from one another depending on each specific decomposition step at which the metal atom-containing molecules are obtained, the molecules being then introduced into a film-forming chamber in order to make them react on a substrate. For instance, when a film is formed using the metal-containing molecules obtained at a step in which the organic raw material is not yet sufficiently decomposed, a large quantity of organic components are taken in the resulting film and this may impair the crystallizability of the film. On the other hand, when a film is formed using the metal-containing molecules obtained at a step in which the organic raw material is excessively decomposed, there is observed the gas phase decomposition and particles are thus formed in a large quantity. Nevertheless, the conventional oxide thin film-forming methods do not define the conditions which are applied while taking into consideration such decomposition processes of raw materials and the conventional oxide thin film-forming apparatuses also do not have a structure which is applied while taking into consideration such decomposition processes of raw materials. Therefore, the resulting thin film never has satisfactory and desired characteristic properties as compared with those observed for a single crystalline film.

In the case of the conventional oxide thin film formed according to the CVD technique, for instance, a ferroelectric oxide material such as a Pb(Zr, Ti)O₃ (hereunder referred to as "PZT") film, it is in general difficult to prevent the occurrence of any crystal defect and it was found that the film had a leak electric current density of about 1E-6. In this case, if the amount of oxygen (the rate of oxygen flow rate in the film-forming gas) to be incorporated into a raw material is increased, such a leak electric current density may be reduced. However, the increase in the oxygen amount leads to the inhabitation of any movement of atoms during crystal growth, and thus the resulting film has a high rate of an amorphous film and/or a paraelectric layer whose orientation differs from that observed for the ferroelectric film and accordingly, the resulting film is inferior in the ferroelectric characteristic properties. Contrary to this, when reducing the rate of oxygen flow rate, the resulting film has a structure quite close to that of the epitaxially grown film or comprises regularly oriented molecules, but there has been observed a large amount of residual organic substances and oxygen defects and this leads to an increase of the leak electric current density. In this case, a raw material such as Pb(thd)₂, Zr(dmhd)₄ or Ti(i-PrO)₂(thd)₂ is a solid at ordinary temperature and therefore, a PZT film is formed by conveying the raw material in the form of a solution in a solvent such as tetrahydrofuran or cyclohexane; vaporizing the solution at a high temperature; admixing the vapor with oxygen gas; and then introducing the resulting mixture in a CVD reaction chamber to thus deposit a PZT film on a substrate. In this respect, the raw gas admixed with oxygen is introduced into the reaction chamber while the gas is decomposed.

### Disclosure of the Invention

### Problems to be solved by the Invention

Accordingly, it is in general an object of the present invention to solve the foregoing problems associated with the conventional techniques and more specifically, it is an object of the present invention to provide a method for preparing a thin film according to the chemical vapor phase growth method which permits the production of an oxide thin film having excellent characteristic properties by optimizing the rate of the oxidation gas flow rate and the activation of the raw gas, and further by reducing the occurrence of oxygen defects of the oxide thin film obtained from the foregoing organic material and simultaneously promoting the epitaxial growth of the thin film to thus improve the quality of the resulting film.

### Means for solving the problems

According the present invention, there is provided a method according to claim 1 for preparing an oxide thin film on a substrate which comprises the steps of admixing a raw gas obtained through the vaporization of a raw material for the oxide thin film, a carrier gas for assisting the transport of the raw gas and an oxidation gas in a gas-mixing unit and supplying the resulting gas mixture on a heated substrate placed in a reaction chamber as a chemical vapor phase growth apparatus through a shower plate to thus make the gas mixture react with one another, wherein a rate of oxidation gas flow rate is not less than 60% , preferably 60% ~ 95%, on the basis of the gas mixture. If the rate of the oxidation gas is less than 60%, the leak electric current increases due to the oxygen loss. The use of the oxidation gas that a rate of the oxidation gas flow rate is not less than 60% would permit the realization of the desired epitaxial growth and the production of a crystal almost free of defects. Moreover, an inert gas flows through an evaporator and therefore, the upper limit of the rate of oxidation gas flow rate is in general 95%.

In the foregoing method for preparing an oxide thin film, the gas mixture is supplied in the reaction chamber through a gas activating means which is arranged between the gas-mixing unit and the shower plate, whereby the state of the gas phase decomposition of the raw gas can be controlled and thus the metal atom-containing molecules in a good state can be introduced into the reacting chamber to be used for forming the film. Thus, the resulting thin film has the excellent characteristic properties.

Preferably, the gas activating means is maintained at such a temperature that, when the raw gas is introduced into the shower plate, the raw gas is vapor phase decomposed into metal atom-containing molecules, which can prepare a film having desired characteristic properties, in the gas activating means. By maintaining the gas activating means at the temperature that is able to control the state of gas phase decomposition of the raw gas, the film having the excellent characteristic properties can be prepared. In this case, the gas activating means should be maintained at a temperature ranging from a temperature without causing any liquefaction or deposition of the raw gas to that without causing film -formation thereof. This temperature is dependent on the raw gas to be used. In general, this temperature is within the range of room temperature to 400°C, preferably 165~360°C, more preferably 165~250°C.

It is preferred that the foregoing method makes use of a gas selected from the group consisting of oxygen, ozone, NO₂ and N₂O as the oxidation gas.

It is preferred that the foregoing method makes use of the carrier gas used is an inert gas selected from the group consisting of nitrogen, helium, argon, neon and krypton gases as the carrier gas.

In the foregoing method, the substrate is preferably one prepared from a material selected from the group consisting of Pt, Ir, Rh, Ru, MgO, SrTiO₃, IrO₂, RuO₂, SrRuO₃ and LaNiO₃.

In the foregoing method for preparing the oxide thin film, the oxide thin film is an oxide of a paraelectric dielectric material selected from the group consisting of SiO₂, TiO₂, Al₂O₃, Ta₂O₅, MgO, ZrO₂, HfO₂, (Ba, Sr)TiO₂ and SrTiO₃; or an oxide of a ferroelectric material selected from the group consisting of Pb(Zr, Ti)O₃, SrBi₂Ta₂O₉ and Bi₄Ti₃O₁₂.

According to the present invention, as discussed above, by using the oxidation gas of specified rate of flow rate and by using specified gas activating means, optimized decomposition step of the raw gas can be obtained, and the good epitaxial growth without oxide defect is realized and thus the oxide thin film having excellent characteristic properties can be prepared.

### Effect of the invention

According to the present invention, it is accomplished an effect that the epitaxial growth of a film is promoted and a oxide thin film having regular orientation and, a low leak current density and whose spontaneous polarization is saturated at a low voltage can be in fact prepared by using the oxidation gas of rate of the flow rate such that prescribed the partial pressure of the oxygen is obtained. Moreover, metal atom-containing molecules obtained in the decomposition step of the raw gas which permits the preparation of films having good characteristic properties are introduced into the reaction chamber to use the molecules for the preparation of the oxide thin film. Thus, it becomes possible to prepare the thin film having an improved oxygen defects. Furthermore, by arranging the gas activating means between the gas-mixing unit and the shower plate, there is accomplished an effect that there can be provided an apparatus for preparing the thin film having the improved oxide defect.

### Description of the Preferred Embodiments

According to the present invention, not only in the case of a film obtained by a single film-forming process, but also in the case of a film obtained by the plural film-forming processes in succession while changing a rate of the oxidation gas flow rate, it is possible to prepare a thin film having good characteristic properties such as a low leak electric current densities and a low polarization-inversion saturation voltages. The thin film obtained by successive process of the latter is more excellent in the characteristic property than that of the former. Furthermore, according to the film-forming apparatus of the present invention, the foregoing oxide thin film can be prepared efficiently.

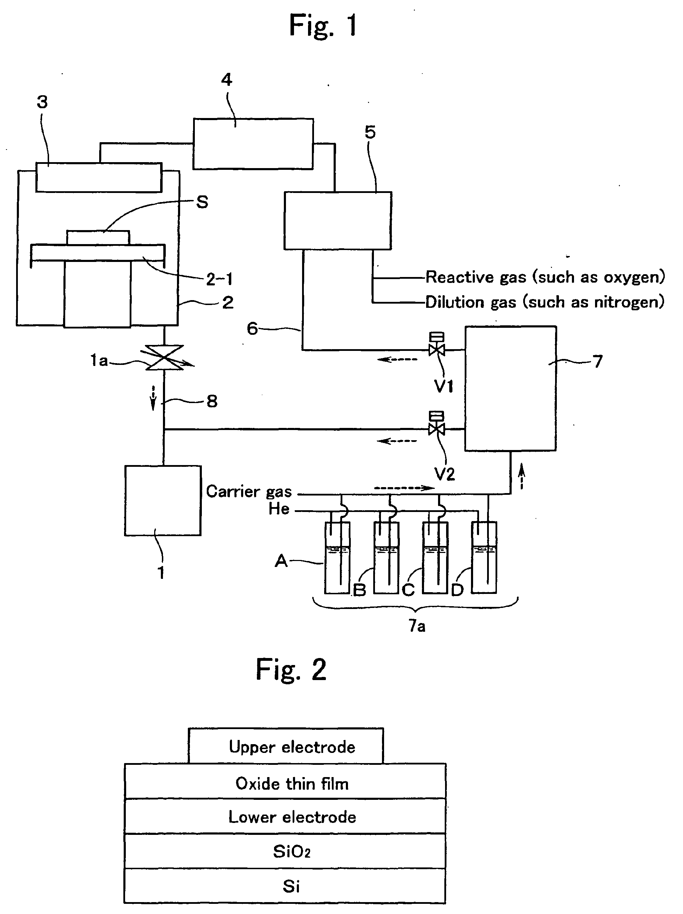

The present invention will hereunder be described in more detail with reference to Fig. 1 which is a schematic diagram showing an example of the structure of a thin film-forming apparatus according to the present invention.

The CVD thin film-forming apparatus as shown in Fig. 1 comprises a vacuum exhaust system 1, a reaction chamber 2 connected to the vacuum exhaust system 1 through a pressure-control valve 1a, a shower plate 3 arranged at the upper portion of the reaction chamber 2, a gas activating means 4, a gas-mixing unit 5, an evaporator 7 serving as a vaporization system connected to the gas-mixing unit 5 through a raw gas-pipe line 6. A raw material which is evaporated in the evaporator 7 is mixed with a reaction gas and a dilution gas in the gas-mixing unit 5, and then a gas mixture thus obtained is introduced into the shower plate 3. In the conventional apparatus, this gas mixture is introduced into the shower plate directly. Contrary to this, in the present invention, the gas activating means is arranged between the shower plate 3 and the gas mixing unit 5, and the gas mixture is introduced into the shower plate through the gas activating means. This gas activating means may be, for example, a gas pipe line. The pipe line 6 is provided with a valve V1 positioned between the evaporator 7 and the gas-mixing unit 5, while a pipe line 8 is equipped with a valve V2 positioned between the evaporator 7 and the vacuum exhaust system 1 so that the evaporator 7, the gas-mixing unit 5 and the vacuum exhaust system 1 can be isolated from one another. Each of the structural elements for these evaporator 7, gas-mixing unit 5 and vacuum exhaust system 1 differ from one another in the maintenance cycle and therefore, when they are opened to the air, substances such as moisture which may adversely affect the films formed may be adhered to these elements. For this reason, these members are isolated from one another to prevent the adhesion of any such harmful substance. More specifically, the apparatus of the present invention is so designed that when one structural element is opened to the air to perform the maintenance thereof, the other two elements can be maintained at a vacuum without opening them to the air.

The foregoing gas activating means 4 is equipped with a heating means such as a heater, ultraviolet rays heating unit, micro wave heating unit, or plasma heating unit. These heating means serve to maintain the gas activating means at the temperature without causing any liquefaction, deposition, or film-formation of the raw gas. Thus, while the gas mixture passes through the gas activating means, the raw material is vapor phase decomposed in the step at which it is possible to obtain the film having good characteristic properties, and the gas mixture containing suitable metal atom-containing molecules thus obtained can be introduced into the reaction chamber. For this reason, a temperature of the gas activating means is set at a temperature from room temperature to 400°C, preferably 165~360°C, more preferably 165~250°C to perform the film-forming process, depending on the raw materials to be used. If set temperature is too low, deposition of the raw gas is caused, and this would result in the generation of particles. If the set temperature is too high, the raw material is too decomposed to thus generate of particles. In addition, the gas mixture after passing through the gas activating means is preferably introduced into the shower plate directly.

Each of the foregoing structural elements will be detailed below.

In the reaction chamber 2, there is arranged a stage 2-1 for mounting a substrate S to be covered with a desired film, which is provided with a means for heating the substrate and a gas mixture for film forming is supplied onto the surface of the substrate heated through the shower plate 3. The excess gas mixture which is not used for the reaction with the substrate S, the by-product gas generated through the reaction of the gas mixture with the substrate and a part of the reaction product gas are discharged by the action of the exhaust system 1. The shower plate 3 is moderately heated to thus maintain the same to a temperature which never causes any liquefaction, deposition and/or film-formation of the introduced gas.

The shower plate 3 positioned at the upper portion of the reaction chamber 2 may be equipped with a particle capture or trap serving as a filter for trapping particles present in the gas mixture. This particle capture may be arranged at a position immediately before the shower hole of the shower plate and it is appropriately and desirably controlled to a temperature which can ensure the prevention of any adhesion and/or capture of the vaporized specific raw element required for the reaction.

The apparatus can easily cope with a variety of pressure conditions for forming a film due to the presence of the pressure-control valve 1a arranged between the foregoing exhaust system 1 and the reaction chamber 2.

The gas-mixing unit 5 is connected to the evaporator 7 through the pipe line equipped with the valve V1 and likewise simultaneously connected to two gas sources (for instance, an oxidation gas source such as an oxygen source; a dilution gas source such as an inert gas (such as nitrogen gas) source) through a valve, a heat-exchanger and a mass controller (not shown). The gas mixture prepared by uniformly admixing desired gaseous components in the gas-mixing unit 5 passes through the gas activating means 4, is then introduced into the reaction chamber 2 through the shower plate 3 and supplied onto the surface of the subject on which a film is formed and which is mounted on the stage 2-1 without forming any laminar flow in the reaction chamber.

The oxidation gas supplied from the oxidation gas source and heated to an appropriate temperature, the raw gas generated in the evaporator 7 and supplied through the pipe line 6 maintained at a temperature which never causes any liquefaction, decomposition and/or film-formation of the gas, and the inert gas are introduced into and admixed in the gas-mixing unit 5 to thus form a gas mixture (a uniform mixture of oxidation gas and raw gas). The raw gas is a gas mixture containing one or a plurality of raw gases. The gas mixture thus prepared is fed to the reaction chamber through the gas activating means 4.

These gas activating means 4 and pipe line 6 may be connected to one another through a VCR joint and a VCR gasket for a part of the joint of the pipe line is not a simple ring, but may be provided with a VCR type particle capture at the hole thereof. The joint provided with such a VCR type particle capture is desirably set and maintained at a temperature higher than that accompanied by the liquefaction, decomposition and/or film-formation of the raw gas so as not to cause any adhesion and/or capture of the specific vaporized raw element required for the reaction.

The gas activating means 4 positioned between the gas-mixing unit 5 and the shower plate 3 may be provided with a valve for switching the gas mixture on the secondary side of the gas-mixing unit 5. The valve is connected to the reaction chamber 2 at the downstream side thereof. The valve is opened when a film is formed and it is closed after the completion of the film-forming step.

The evaporator 7 is connected to a raw material-supply zone 7a and an evaporation zone (not shown). The evaporator is so designed that it pressurizes and transports liquid raw materials A, B and C prepared by dissolving liquid or solid raw materials in organic solvents through the use of a pressurized gas (for instance, an inert gas such as He gas), the flow rates of these liquid raw materials fed under pressure are controlled by corresponding flow rate controllers and the liquid raw materials are thus transported to the evaporation zone by the action of a carrier gas. The evaporator is likewise so designed that the liquid raw materials whose flow rates are controlled can efficiently be evaporated in the evaporation zone and the resulting raw gas can be fed to the gas-mixing unit 5. The evaporation zone permits the mixing and evaporation of a single liquid raw material or a plurality of liquid raw materials. The evaporation of a liquid raw material is preferably carried out not only by evaporating droplets of the liquid raw material, but also by injecting a gas stream to these droplets or applying physical vibrations or ultrasonics to the droplets, converting the liquid particles thus formed into finer particles by passing through a nozzle positioned on the wall of the evaporation zone prior to the introduction thereof into the evaporation zone and then evaporating these liquid particles to thus improve the evaporation efficiency. It is preferred that evaporation members produced from a material excellent in the heat conduction such as Al may be disposed within the evaporation zone so that liquid particles or droplets can quite efficiently be evaporated in place and to reduce liquid particle-evaporation loads of a variety of particle captures. In addition, a particle capture may be arranged in the evaporation zone such that any particle originated from the residue generated when the liquid raw material is evaporated is never discharged from the evaporation zone and that the droplets entering into the zone in a small amount can be evaporated without external evacuation of the same by the action of a vacuum. In this respect, it is desirable that the evaporation members and the particle capture be maintained at an appropriate temperature as an evaporation condition so as to certainly evaporate droplets and fine liquid particles which come in contact with these components and to prevent the adhesion of any evaporated specific raw element required for the reaction to these components and/or the capture of such element by these components. Alternatively, the evaporator 7 may likewise be so designed that it comprises a solvent D for the dissolution of the raw material and that the resulting solution is introduced into the evaporation zone while controlling the flow rate thereof by a flow rate controller to thus evaporate the solution and to thus prepare a solvent gas. The solvent gas may be used for the cleaning of the interior of the apparatus.

As has been described above, the apparatus for preparing the thin film of the present invention preferably comprises a reaction chamber 2 having a cylindrical shape and the reaction chamber is provided therein with a substrate stage 2-1 likewise having a cylindrical shape on which a substrate such as a silicon wafer is mounted. A heating means is incorporated into the stage 2-1 to heat the substrate. Moreover, the reaction chamber 2 may be provided with a means for freely ascending and descending the stage 2-1 between the film-forming position within the reaction chamber and the substrate-conveying position at a lower position in the chamber. The apparatus is likewise so designed that a shower plate 3 is disposed at the central portion on the upper side of the reaction chamber 2 so that it is opposed to the substrate stage 2-1 and that the film-forming gas from which the particles are removed can be injected towards the center of the substrate through the shower plate 3.

Incidentally, when preparing a thin film on a substrate according to the CVD technique such as the MOCVD technique, particles are separated out from a raw gas when the temperature of the gas is reduced to not more than a predetermined level and these particles may become a cause of film-forming dust within the reaction chamber. For this reason, the pipe line for the oxidation gas is provided with a heat-exchanger as a means for controlling the gas temperature and a heating means such as a heater is fitted to the outer wall of the reaction chamber 2 and/or the substrate stage 2-1 to thus prevent the separation of any raw gas.

The method for the preparation of the present invention using the apparatus for preparing the thin film shown in Fig.1 would permit the formation of a PZT ferroelectric film according to the CVD technique using, as a raw material, an organometal compound, for instance, a liquid raw material such as Pb(DPM)₂, Zr(DMHD)₄ or Ti(i-PrO)₂(DPM)₂; the formation of CVD thin film of PZT; and the formation of a BST ferroelectric film according to the CVD technique using a liquid raw material such as Ba(DPM)₂, Sr(DPM)₂, or Ti(i-PrO)₂(DPM)₂; as well as the formation of a thin film mainly used as a metallic wire distribution of, for instance, Cu and Al, a thin film mainly used as a barrier of, for instance, TiN, TaN, ZrN, VN, NbN and Al₂O₃, or a thin film of a dielectric material such as SBT and STO according to the CVD technique.

In the present invention, the raw gas is one obtained by heating and vaporizing, a raw material which is a gas, liquid or solid in ordinary temperature. Also the raw gas may be one obtained by vaporizing a liquid raw material or a solution of a solid raw material in a solvent.

According to another embodiment of the present invention, the gas mixture also can be introduced into the reaction chamber through a pipe line which is equipped with the foregoing heating means and serves as the gas activating means 4 arranged between the gas-mixing unit 5 and the shower plate 3 shown in Fig. 1. The pipe line permits the desired activation of the gas if a surface area of inner wall thereof is within the range of 4.8 × 10⁻³m² to 1.28 × 10⁻¹m². Such a structure of the pipe line would permit the activation of the raw gas and the realization of excellent epitaxial growth. More specifically, the decomposition step of the raw material to be introduced into the reaction chamber can be optimized to thus obtain the desired metal atom-containing molecules. Thus, the film is formed efficiently and the film properties (such as leak electric current density, polarization-inversion charge density and polarization-saturation voltage) are improved. If the surface area of inner wall of the pipe line is less than 4.8 × 10⁻³m², the gas of organic material is insufficiently decomposed and accordingly, the resulting film has a large amount of oxygen loss therein. If the surface area of inner wall thereof is too large, the vapor phase decomposition of the raw gas is caused, and a problem arises such that the film-forming rate decreased due to deposition on the inner wall of the pipe line, the consumption of the raw material increases, and the production cost becomes high due to increases in the surface area of the apparatus and the number of parts whose temperature should be controlled. Accordingly, the preferred and acceptable upper limit of the internal wall surface area is about 1.28 × 10⁻¹m². Alternatively, depending on an internal diameter of the pipe line, if the inner diameter of the pipe line is one which is used in general (almost 105 ~ 20.5mm) and a length of the pipe line is about 150~1625mm, it is possible to accomplish the some effect.

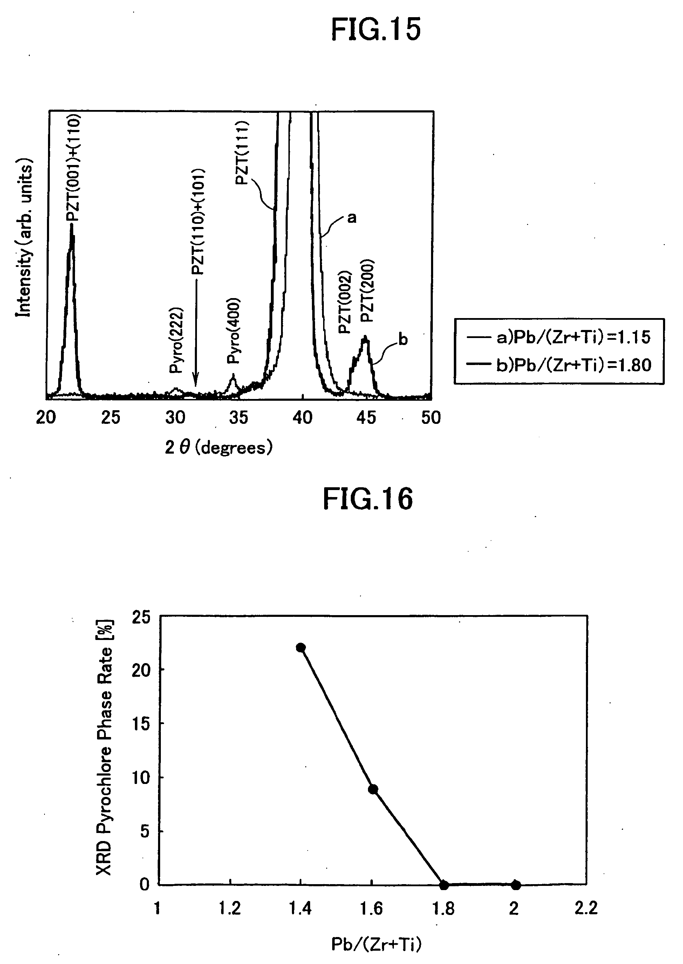

According to the present invention, when using a substrate in which a prescribed atom present in the oxide thin film to be produced can easily diffuse, the amount of the atom to be contained in the initial layer is preferably heightened to a level higher than in the substrate in which the atom hardly diffuses. This would permit the desired epitaxial growth of a film. For instance, in the case of using a substrate, such as Pt or SRO substrate, into which Pb can easily diffuse, a ferroelectric film free of any foreign phase and capable of saturating the spontaneous polarization at a low voltage could be prepared by increasing the rate of Pb in the seed layer (initial layer). In this regard, Fig.15~22, which will hereinafter be explained, make it clear.

The present invention having the foregoing construction permits the improvement of any oxygen defect. Moreover, the epitaxial growth of a film can be promoted and a ferroelectric thin film having a regular orientation and a low leak electric current and whose spontaneous polarization is saturated at a low voltage can be prepared by forming a seed layer ( an initial layer) during the nucleation in a lower rate of oxidation gas flow rate and successively increasing the rate of oxidation gas flow rate to grow a film at the oxidation gas rate that is higher than that used in the initial layer

The present invention will hereunder be described in more detail with reference to the following Examples in which a PZT ferroelectric thin film is prepared according to the MOCVD technique using the thin film-forming apparatus shown in Fig. 1, be way of example.

### Example 1

Solutions of Pb(thd)₂, Zr(dmhd)₄ and Ti(i-PrO)₂(thd)₂ as a solid raw material which were dissolved in tetrahydrofuran (THF) as a solvent in a concentration of 0.3 mole/L and accommodated in containers A, B and C, respectively, and THF contained in a container D were pressurized by helium gas and fed to the evaporator 7 by the action of nitrogen as a carrier gas to thus evaporate them therein. The raw gas thus obtained through evaporation was transported to the gas-mixing unit 5 through the pipe line 6, the raw gas was admixed with oxygen (flow rate of 3500 sccm) as an oxidation gas and nitrogen (300 sccm) as a dilution gas, the resulting mixed gas was then transported to the shower plate 3 through the gas activating means 4, and the gas mixture was then fed to the surface of a substrate S mounted in the reaction chamber 2 and heated to a temperature of 620°C to deposit a PZT thin film and to thus form a desired thin film.

In the foregoing film-forming process, the pressure in the reaction chamber was adjusted to about 667 Pa using a pressure control valve 1a. In general, the pressure in the reaction chamber was adjusted to about 133.3Pa ~ 3999Pa so that the pressure in the gas activating means 4 is a little higher than that of the reaction chamber. In addition, the temperature of the gas activating means needs to control to a level which never causes any deposition of the raw material. In the case of Pb(thd)₂ complex used in this Example, the temperature adjusted to the level ranging from about 210 to 250°C.

As has been described above, in this Example, a film was formed while the temperature of the substrate S was maintained at 620°C by heating the substrate stage 2-1, but the film-forming process was in general carried out at a temperature ranging from about 500 to 650°C.

The substrate used above was one comprising a Si wafer on which a SiO₂ film had been formed through thermal oxidation and a lower electrode had likewise been formed on the SiO₂ film surface in the form of a film. The lower electrode may be formed from a material such as Pt, Ir, Rh, Ru, MgO, SrTiO₃, IrO₂, RuO₂, SrRuO₃ and LaNiO₃, which are oriented in a certain plane direction, but Ir/SiO₂/Si, Pt/Ti/SiO₂/Si and SRO/Pt/Ti/SiO₂/Si were used in this Example.

As shown in Fig. 2, a PZT ferroelectric oxide thin film was formed on the lower electrode according to the foregoing procedures in a thickness of 100 nm, a Pt film as an upper electrode was formed on the oxide thin film by the sputtering through a mask (a diameter of 0.3 mm) for the evaluation of electric characteristics of the resulting PZT ferroelectric oxide thin film. The resulting structure was used in the following Examples as a sample for the evaluation of a variety of characteristic properties.

### Example 2

In this Example, the dependency of various characteristic properties of the PZT thin film on the surface area of inner wall of the gas activating means arranged between the gas-mixing unit and the shower plate will be detailed.

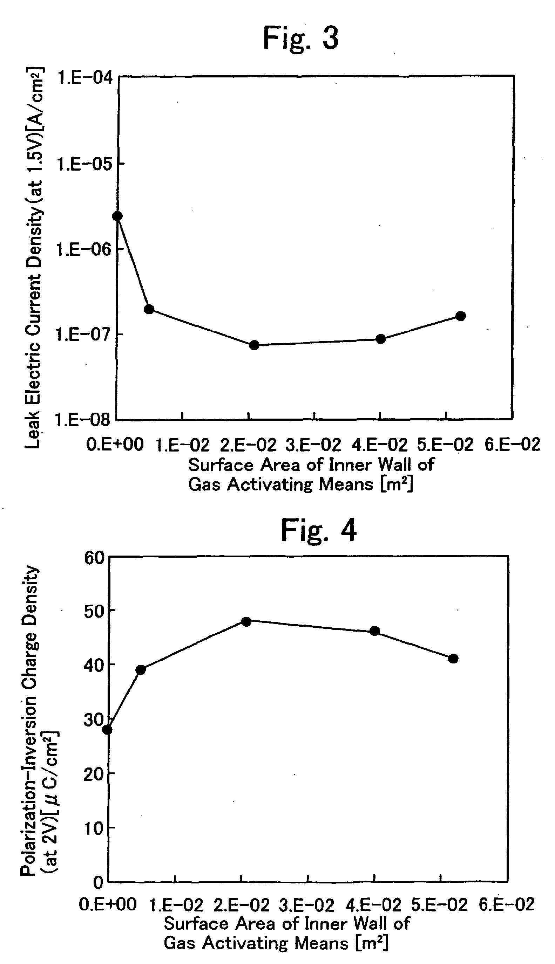

Fig. 3 is a graph showing the dependency of the leak electric current density (A/cm²) of the PZT thin film, observed when a voltage of 1.5 V is applied thereto, on the surface area (m²) of inner wall of the gas activating means. In this case, the rate of oxygen gas flowing through the reaction chamber 2 was set at 91% on the basis of the total gas supplied. The substrate used was an Ir(111)-oriented film. The leak electric current density was found to be 2.5E-6A/cm² in the case of not using the gas activating means (a surface area of inner wall is 0m²) and 2.0E-7 A/cm² for a surface area of inner wall of the gas activating means of 4.8E-3 m². However, if the surface area of inner wall of the gas activating means was increased, the leak current density was reduced and it reached a minimum value of 7.5E-8A/cm² at the surface area of inner wall of 2.1E-2 m². On the other hand, if the surface area of inner wall was further increased, the leak current density was increased and it was found to be 1.7E-7A/cm² for a surface area of inner wall of 5.2E-2m².

Fig. 4 is a graph showing the dependency of the polarization-inversion charge density of the PZT thin film, observed when a voltage of 2.0 V is applied thereto, on the surface area of inner wall of the gas activating means. In this case, the rate of oxygen gas flow rate and the substrate used were the same as those used above. The polarization-inversion charge density of the film was found to be 28µC/cm² without using the gas activating means and 39µC/cm² at a surface area of inner wall of 4.8E-3 m². However, it was increased as a surface area of inner wall was increased and the charge density reached a maximum value of 48µC/cm² at the surface area of inner wall of 2.1E-2 m². On the other hand, if a surface area of inner wall was further increased, the polarization-inversion charge density was reduced and it was found to be 40µC/cm² at surface area of inner wall of 5.2E-2m²

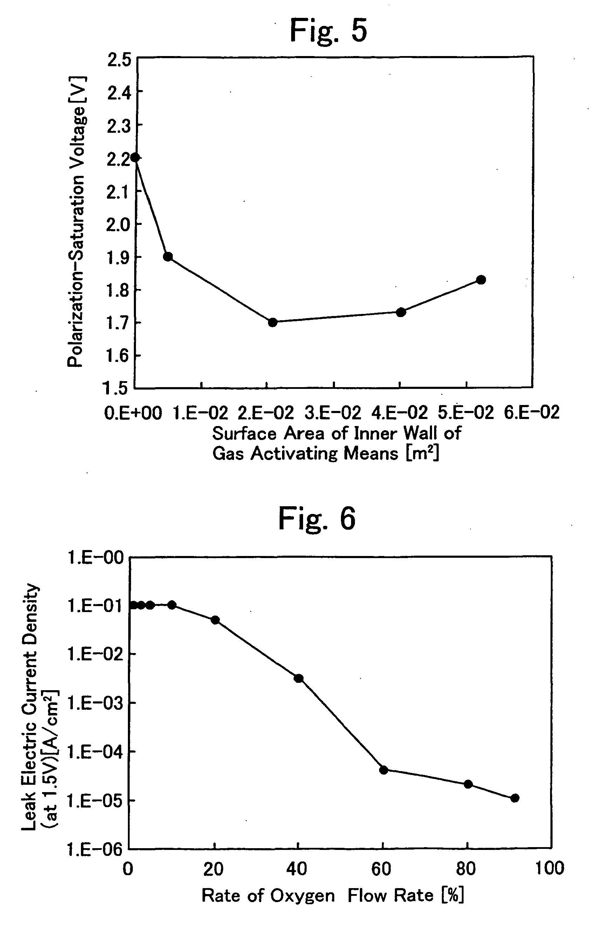

Fig. 5 is a graph showing the dependency of the polarization-saturation voltage of the PZT thin film on the surface area of inner wall of the gas activating means. In this case, the flow rate of oxygen gas and the substrate used were the same as those used above. The polarization-saturation voltage of the film was found to be 2.2 V without using the gas activating means and 1.90 V at the surface area of inner wall of 4.8E-3 m². However, it was reduced as the surface area of inner wall was increased and the voltage reached a minimum value of 1.7 V at the surface area of inner wall of 2.1E-2 m². On the other hand, if the surface area of inner wall is further increased, the polarization-saturation voltage of the film was increased and it was found to be 1.83 V at the surface area of inner wall of 5.2E-2m².

As has been described above, though the decomposition processes of organic materials have not yet been clearly elucidated, it has been assumed that the organic material used in this invention is decomposed into several tens of intermediates and stable molecules (in the case of THF solvent, at least 200 kinds of intermediates and stable molecules are present) during its decomposition step. It would be considered that only parts of metal atom-containing molecules among them contribute to the formation of a film. The results obtained in this Example clearly indicate that characteristic properties (such as the leak current density, polarization-inversion charge density and polarization-saturation voltage) of the resulting films differ from one another depending on each specific decomposition step from which the metal atom-containing molecules are collected, the molecules being then introduced into a reaction chamber in order to make them react on a substrate.

The inventors of this invention have determined the decomposition steps of metal atom-containing molecules and have found that after mixing the oxidation gas and the raw gas obtained through evaporation, the gas activating means which control the state of gas phase decomposition are arranged, and that the metal atom-containing molecules obtained at the steps which permit the preparation of films having good characteristic properties must be introduced into the reaction chamber through the shower plate in order to efficiently form a film and to improve the characteristic properties of the resulting film.

### Example 3

The dependency of characteristic properties of the PZT thin film on the rate of the oxygen flow rate will be detailed in this Example.

Fig. 6 is a graph showing the dependency of the leak electric current density of the PZT thin film, observed when a voltage of 1.5 V is applied thereto, on the flow rate of oxygen in the gas mixture on the basis of the total gases introduced. In this case, the rate of oxygen flow rate is changed within the range of 0.5 - 95%, a surface area of inner wall of the gas activating means was set at 2.1E-2 m² and the substrate used was an Ir(111)-oriented film. When the oxygen flow rate was 1%, the leak current density was found to be 1E-1 and it was gradually reduced as the oxygen flow rate was increased.

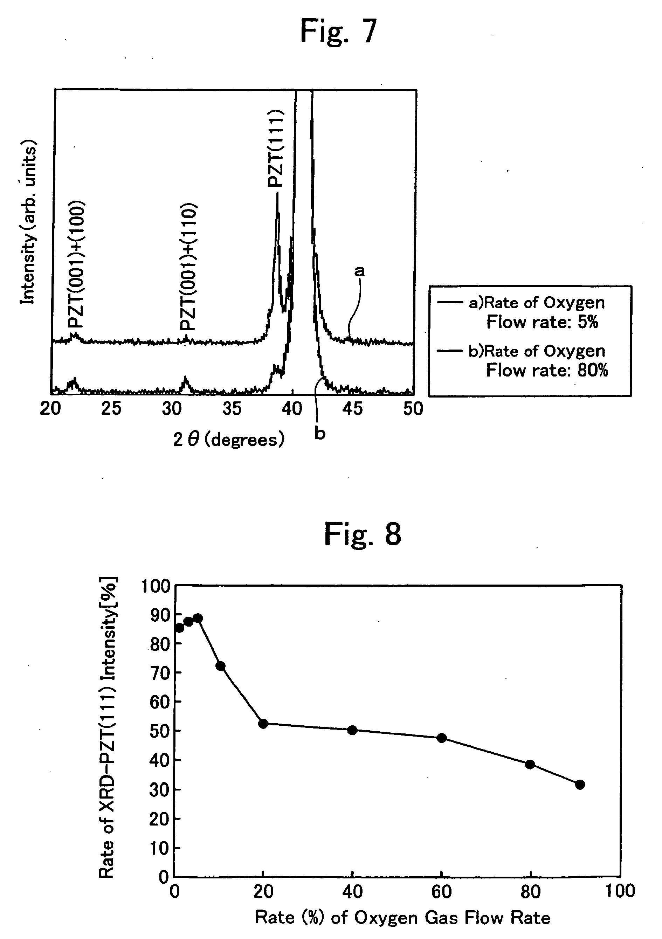

As shown in Fig. 7, however, the X-ray diffraction (XRD) pattern determined for the PZT thin film clearly indicate that the (111)-orientation intensity observed at an oxygen flow rate of 80% (the pattern b in Fig. 7) was significantly reduced as compared with that observed at an oxygen flow rate of 5% (the pattern a in Fig. 7). In the case of Fig.7, Pb / (Zr + Ti) equal to 1.15. Fig. 8 is a graph showing the dependency of the rate of the PZT(111) intensity on the basis of the total orientation intensity of the PZT thin film as determined by the XRD while changing the rate of oxygen flow rate (0.5 to 95%), in the gas mixture. The XRD(111) intensity was reduced as the oxygen flow rate was increased. From the foregoing, it would be recognized that the reduction of the leak electric current density and the epitaxial growth of the film are in a trade-off relation.

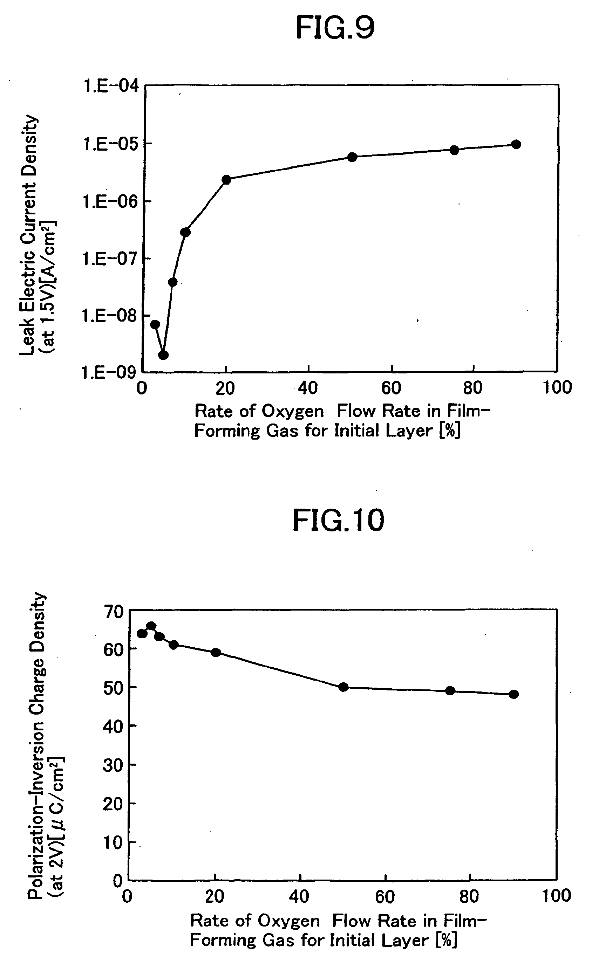

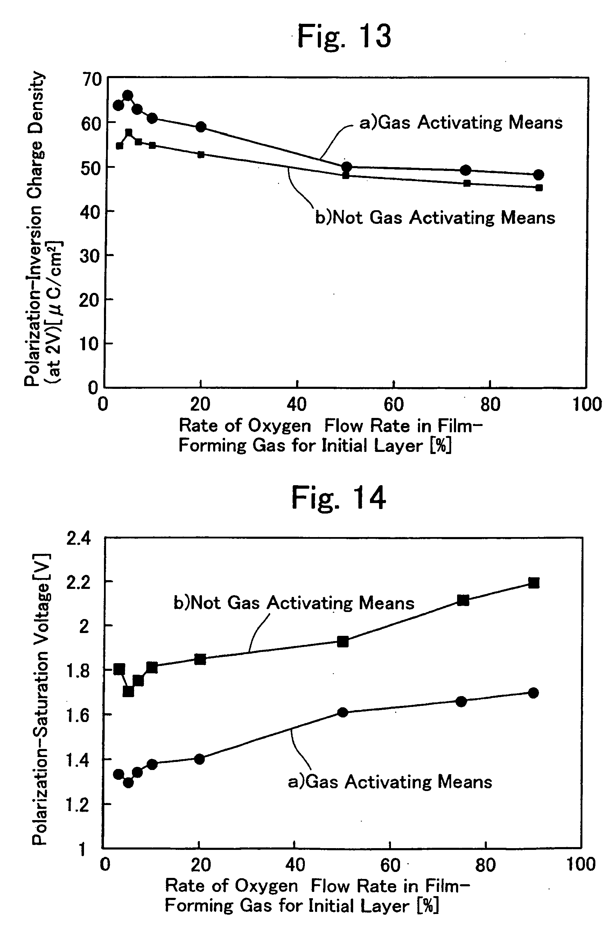

Thus, in this Example, a film was epitaxially grown while changing the oxygen flow rate (0.5 - 60%) in the gas mixture for using in forming the initial layer (hereunder referred to as "initial layer-oxygen flow rate")during nucleation and then the film as the second layer is formed thereon in succession while changing the oxygen flow rate to 91%. Thus characteristic properties of the resulting PZT thin film were determined, and the results are shown in Figs. 9~14.

Fig. 9 is a graph showing the dependency of the leak electric current density of the PZT thin film, observed when a voltage of 1.5 V is applied thereto, on the initial layer-oxygen flow rate in the preparation of the initial layer. In this case, the thicknesses of initial and second layers were set at 5 nm and 100 nm, respectively. The leak current density was found to be a minimum of 2E-9 for an initial layer-oxygen flow rate of 5% and it was increased as the initial layer-oxygen flow rate was increased. It is recognized from the Fig. 9 that leak electric current density is sufficiently low even when the rate of oxygen flow rate for forming the initial layer is 0.5%, the desired value of the leak electric current density is obtained if the rate of oxygen flow rate is up to less than about 60%, preferably up to about 20%.

Fig. 10 is a graph showing the dependency of the polarization-inversion charge density of the PZT thin film, observed when a voltage of 2.0 V is applied thereto, on the initial layer-oxygen flow rate in the preparation of the initial layer. The polarization-inversion charge density reached a maximum value of 66 µC/cm² at an initial layer-oxygen flow rate of 5% and thereafter, it was reduced as the initial layer-oxygen flow rate was increased. It is recognized from the Fig.10 that the polarization-inversion charge density is sufficiently high even when the rate of oxygen flow rate for forming the initial layer is 0.5%, the desired value of the polarization-inversion charge density is obtained if the rate of oxygen flow rate is up to less than about 60%, preferably up to about 20%.

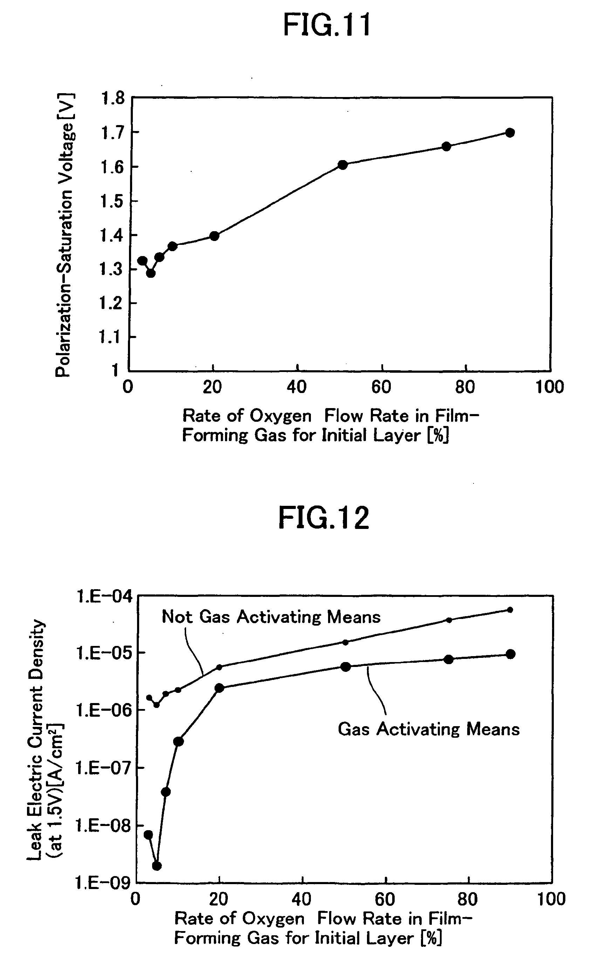

Fig. 11 is a graph showing the dependency of the polarization-saturation voltage on the initial layer-oxygen flow rate in the preparation of the initial layer. The polarization-saturation voltage reached its minimum value of 1.29 V at an initial layer-oxygen flow rate of 5% and thereafter, it was reduced as the initial layer-oxygen flow rate was increased. It is recognized from the Fig. 11 that the polarization-saturation voltage is sufficiently low even when the rate of oxygen flow rate for forming the initial layer is 0.5%, the desired value of polarization-saturation voltage is obtained if the rate of oxygen flow rate is up to less than about 60%, preferably up to about 20%.

Figs. 12, 13 and 14 are graphs showing the dependency of the leak electric current density of the PZT thin film, observed when a voltage of 1.5 V is applied thereto, the polarization-inversion charge density of the PZT thin film observed when a voltage of 2.0 V is applied thereto and the polarization-saturation voltage, on the initial layer-oxygen flow rate in the preparation of the initial layer, which are observed when the apparatus is equipped with the gas activating means (the line a in these figures; the surface area of its inner wall: 2.1E-2m²)and not equipped with the gas activating means. The data shown in these figures clearly indicate that when the apparatus is equipped with the gas activating means, the resulting film has excellent characteristic properties or the film has, a low leak current density, a high polarization-inversion charge density and a low polarization-saturation voltage at all of the oxygen flow rate (0.5 ~ 95%) examined as compared with those observed that when the apparatus is not equipped with the gas activating means.

### Example 4

The dependency of characteristic properties of the PZT thin film formed on a Pt substrate on the Pb/(Zr + Ti) composition in the initial layer will be detailed in this Example. In this case, the surface area of inner wall of the gas activating means arranged between the gas-mixing unit and the shower plate was set at 2.08E-02m², the substrate used was a Pt/Ti/SiO₂/Si substrate.

A monolayer film was prepared and thus the film-forming process was performed at an oxygen flow rate of 91%. Fig. 15 is a diagram showing the X-ray diffraction (XRD) pattern observed for the PZT thin film. The film of Pb/(Zr + Ti)=1.15 (the curve a in Fig. 15) does not show any peak relating to the perovskite phase of PZT, but only the pyrochlore phase was observed. Moreover, there was observed only the PZT perovskite monophase for the film of Pb / (Zr + Ti) =1.80 (the curve b in Fig. 15). Fig. 16 is a graph showing the dependency of the rate of the pyrochlore phase in the XRD intensity on the composition of Pb/(Zr + Ti). There was observed the orientation only for PZT at a Pb/(Zr + Ti) of not less than 1.80, provided that these PZT monophase films had extremely high leak current densities and never showed any ferroelectric characteristics.

Then, an initial layer as a seed layer and a second layer film were formed in succession to thus improve the properties of the resulting thin film. The initial layer for forming initial nuclei was formed at an oxygen flow rate of 5% in a thickness of 5 nm, while changing the ratio: Pb/(Zr + Ti). The second layer was formed at an oxygen flow rate of 91 % in a thickness of 100 nm.

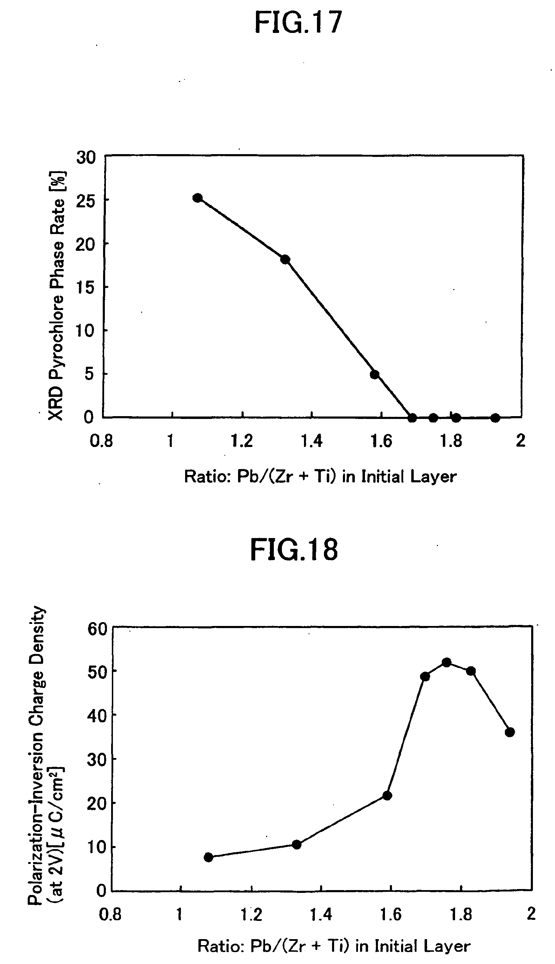

Fig. 17 is a graph showing the dependency of the rate of the pyrochlore phase in the XRD intensity on the composition of Pb/(Zr + Ti) present in the initial layer. From the data shown in Fig. 17, it would be estimated that the PZT monophase is formed at a ratio: Pb/(Zr + Ti) of not less than 1.69.

Fig. 18 is a graph showing the dependency of the polarization-inversion charge density on the composition of Pb/(Zr + Ti) present in the initial layer. The polarization-inversion charge density increases as the ratio: Pb/(Zr + Ti) in the composition of the film increases and the charge density reached a maximum value of 52 µC/cm² at a ratio: Pb/(Zr + Ti) of 1.75. The polarization-inversion charge density was slowly reduced at higher ratios.

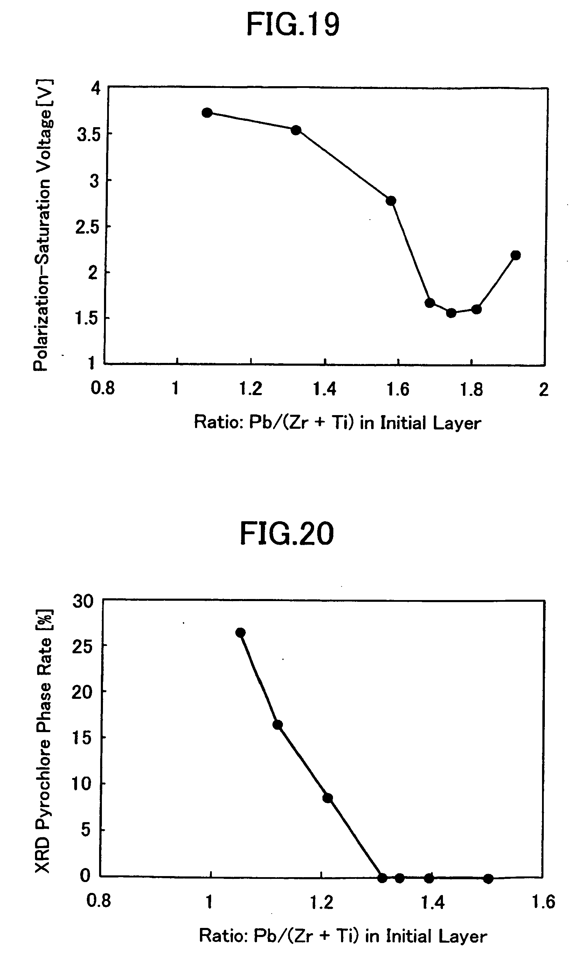

Fig. 19 is a graph showing the dependency of the polarization-saturation voltage on the composition of Pb/(Zr + Ti) present in the initial layer. The polarization-saturation voltage was reduced as the ratio: Pb/(Zr + Ti) in the composition of the film increases and it reached a minimum value of 1.56 V at Pb/(Zr + Ti)=1.75 and it was moderately increased at the rate higher than 1.75.

From these results, it would be estimated that the PZT monophase can be obtained at a ratio: Pb/(Zr + Ti) ranging from 1.69 to 1.82 and that PbO paraelectric layers were mixed therein at a ratio: Pb/(Zr + Ti) of 1.93.

### Example 5

The dependency of characteristic properties of the PZT thin film formed on an SrRuO₃ (SRO) substrate on the composition of a initial layer or the ratio: Pb/(Zr + Ti) in this Example.

Regarding the SRO substrate, it has been confirmed that Pb diffuses in the SRO. In this Example, a initial layer as and a second layer film were formed in succession and the resulting film was inspected for the dependency of characteristic properties of the film on the ratio: Pb/(Zr + Ti) in the initial layer.

Fig. 20 is a graph showing the dependency of the rate of the pyrochlore phase in the XRD intensity on the composition of the initial layer or the ratio: Pb/(Zr + Ti). In this case, an internal surface area of the gas activating means was set at 2.08E-2m² and the substrate used was an SRO/Pt/Ti/SiO₂/Si substrate. An initial layer film was prepared using an oxygen flow rate of 91% and a second layer film was prepared using an oxygen flow rate of 91%. As will be clear from the data plotted on Fig. 20, the rate of the pyrochlore phase is reduced as the ratio: Pb/(Zr + Ti) increases and it was found to be zero at a ratio: Pb/(Zr + Ti) of not less than 1.31.

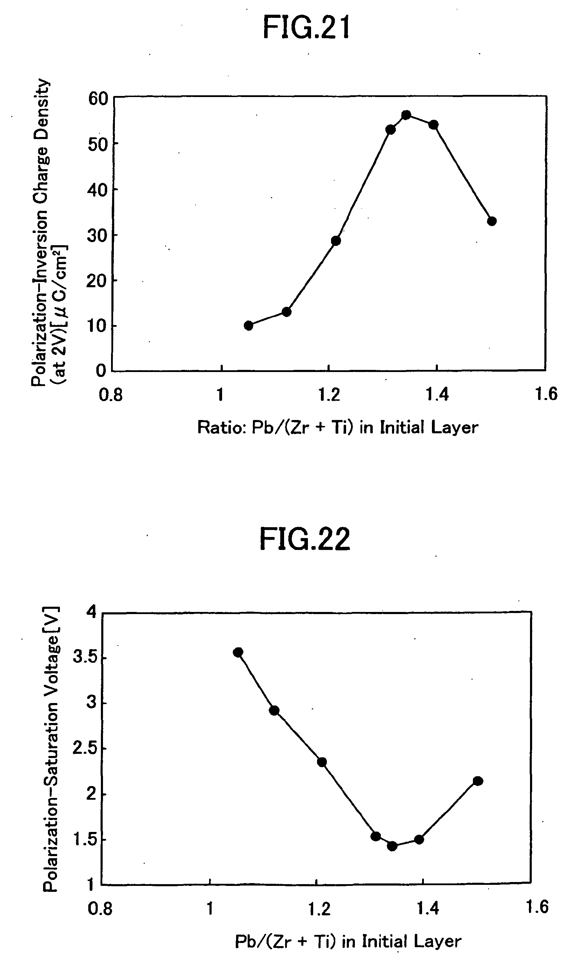

Fig. 21 is a graph showing the dependency of the polarization-inversion charge density on the composition of the initial layer or the ratio: Pb/(Zr + Ti) in the initial layer. The charge density increases as the ratio: Pb/(Zr + Ti) increases and it reached a maximum value of 56 µC/cm² at a ratio: Pb/(Zr + Ti) of 1.31.

Fig. 22 is a graph showing the dependency of the polarization-saturation voltage on the composition of the initial layer or the ratio: Pb/(Zr + Ti) in the initial layer. The polarization-saturation voltage is reduced as the ratio: Pb/(Zr + Ti) increases and it showed a minimum value of 1.41 V at a ratio: Pb/(Zr + Ti) of 1.31.

It is recognized from Figs. 20-22 that PZT monophase is obtained at a ratio: Pb/(Zr + Ti) of not less than 1.31 and the film characteristic property is sufficiently. However, if the film thickness is about 100nm, it is considered that the precipitation of excess Pb on the grain boundary brings about the increase of the leak electric current density. Thus, the object of the present invention can be accomplished by a continued application of film-formation which is performed using the film rich in Pb as the initial layer and the film containing reduced Pb as the second layer.

Next, PZT thin films were prepared according to the foregoing Examples, provided that pipe lines each having a different inner diameter were used as the gas activating means, and the properties of the film thus obtained were compared. Table.1 shows the relation between an surface area of inner wall of each pipe line and a length of each pipe line when the internal diameter of the pipe line is 10.2mm and 25mm.

**(Table 1)**

| Length of the pipe line (mm) | Internal diameter of the pipe line : 10.2mm | Internal diameter of the pipe line : 25mm |
|---|---|---|
| | Surface area of inner wall (m²) | Surface area of inner wall (m²) |
| 40 | 1.28E-03 | 3.14E-03 |
| 150 | 4.80E-03 | 1.18E-02 |
| 650 | 2.08E-02 | 5.10E-02 |
| 1250 | 4.00E-02 | 9.81E-02 |
| 1625 | 5.20E-02 | 1.28E-01 |

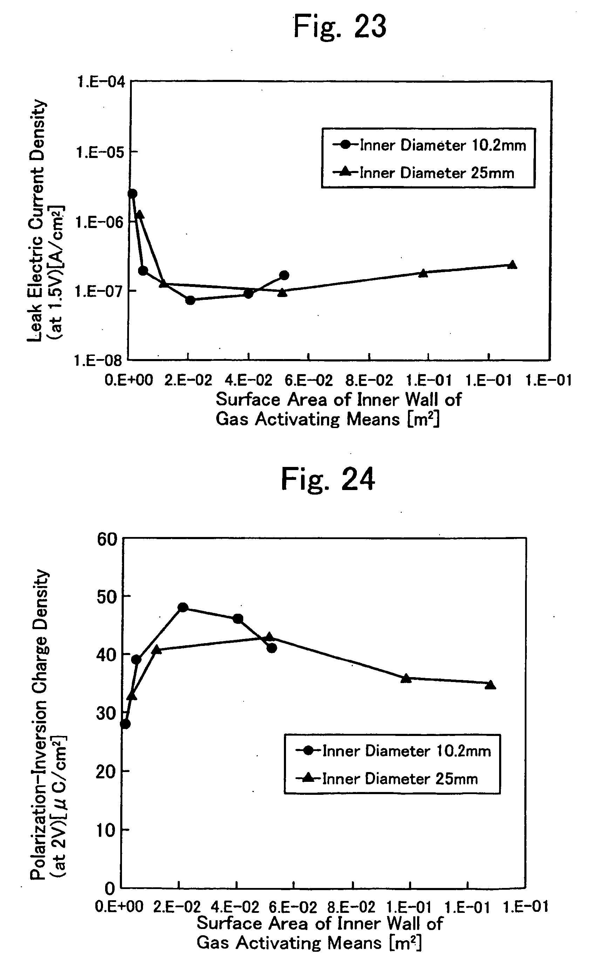

In the case of the above PZT thin film prepared using the thin film-preparing apparatus equipped with the foregoing pipe line as the gas activating means, the rate of the oxygen gas fed to the reaction chamber 2 was 91% (as in the case of Fig.3) on the basis of the total supply gas (gas mixture) . Fig.23 is a graph showing the dependency of the leak current density (A/cm²) of the resulting PZT thin film on the surface areas of inner wall of the pipe lines used as the gas activating means when a voltage of 1.5V is applied thereto. It is clearly recognized from this figure that, if the pipe lines are identical in the surface area of inner wall, the leak electric current density of the thin films is almost identical with each other even if the pipe lines have the different inner diameter.

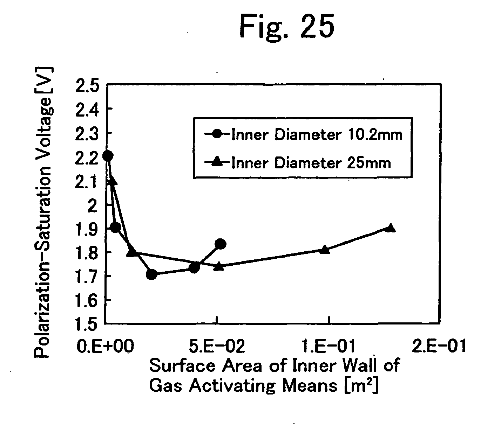

Fig 24 is a graph showing the dependency of a polarization-inversion charge density when a voltage of 2.0V was applied to the PZT thin film obtained according to the foregoing method, and Fig. 25 is a graph showing the dependency of the polarization-saturation voltage on surface area of inner wall of a pipe line used the gas activating means. It can be clearly recognized from these figures that, if the pipe lines are identical in the surface area of inner wall, the polarization-inversion charge density and the polarization-saturation voltage of the thin films show the almost same tendency as in the case of the leak electric current density, even if the pipe lines have the different inner diameter.

### Brief Description of the Drawings

Fig. 1 is a schematic diagram showing an example of the structure of a thin film-forming apparatus according to the present invention.
Fig. 2 is a schematic diagram showing the structure of a sample used for the evaluation of film characteristics in each Example.
Fig. 3 is a graph showing the dependency of the leak electric current density of a PZT thin film, observed when a voltage of 1.5 V is applied thereto, on the surface area of inner wall of the gas activating means.
Fig. 4 is a graph showing the dependency of the polarization-inversion charge density of a PZT thin film observed when a voltage of 2.0 V is applied thereto, on the surface area of inner wall of the gas activating means.
Fig. 5 is a graph showing the dependency of the polarization-saturation voltage of a PZT thin film on the surface area of inner wall of the gas activating means.
Fig. 6 is a graph showing the dependency of the leak electric current density of a PZT thin film, observed when a voltage of 1.5 V is applied thereto, on the rate of oxygen flow rate in the gas mixture on the basis of the total gases introduced.
Fig. 7 is a diagram showing the X-ray diffraction pattern observed for a PZT thin film.
Fig. 8 is a graph showing the dependency of the rate of the PZT (111) intensity, on the basis of the total orientation intensity of a PZT thin film as determined by the XRD, on the flow rate of oxygen in the film-forming gas.
Fig. 9 is a graph showing the dependency of the leak electric current density of a PZT thin film, observed when a voltage of 1.5 V is applied thereto, on the flow rate of oxygen used in the preparation of the initial layer.
Fig. 10 is a graph showing the dependency of the polarization-inversion charge density of a PZT thin film, observed when a voltage of 2.0 V is applied thereto, on the flow rate of oxygen used in the preparation of the initial layer.
Fig. 11 is a graph showing the dependency of the polarization-saturation voltage on the flow rate of oxygen used in the preparation of the initial layer.
Fig. 12 is a graph showing the dependency of the leak electric current density of a PZT thin film, observed when a voltage of 1.5 V is applied thereto, on the flow rate of oxygen used in the preparation of the initial layer.
Fig. 13 is a graph showing the dependency of the polarization-inversion charge density of a PZT thin film, observed when a voltage of 2.0 V is applied thereto, on the flow rate of oxygen used in the preparation of the initial layer.
Fig. 14 is a graph showing the dependency of the polarization-saturation voltage of a PZT thin film on the flow rate of oxygen used in the preparation of the initial layer.
Fig. 15 is a diagram showing the X-ray diffraction (XRD) pattern observed for a PZT thin film.
Fig. 16 is a graph showing the dependency of the rate of the pyrochlore phase in the XRD intensity on the composition of Pb/(Zr+Ti).
Fig. 17 is a graph showing the dependency of the rate of the pyrochlore phase in the XRD intensity on the composition of Pb/(Zr+Ti) present in the initial layer.
Fig. 18 is a graph showing the dependency of the polarization-inversion charge density on the composition of Pb/(Zr+Ti) present in the initial layer.
Fig. 19 is a graph showing the dependency of the polarization-saturation voltage on the composition of Pb/(Zr+Ti) present in the initial layer.
Fig. 20 is a graph showing the dependency of the rate of the pyrochlore phase in the XRD intensity on the composition of Pb/(Zr+Ti) present in the initial layer.
Fig. 21 is a graph showing the dependency of the polarization-inversion charge density on the composition of Pb/(Zr+Ti) present in the initial layer.
Fig. 22 is a graph showing the dependency of the polarization-saturation voltage on the composition of Pb/(Zr+Ti) present in the initial layer.
Fig. 23 is a graph showing the dependency of the leak electric current density of a PZT thin film, observed when a voltage of 1.5 V is applied thereto, on the surface area of inner wall of the gas activating means.
Fig. 24 is a graph showing the dependency of the polarization-inversion charge density of a PZT thin film, observed when a voltage of 2.0 V is applied thereto, on the surface area of inner wall of the gas activating means.
Fig. 25 is a graph showing the dependency of the polarization-saturation voltage on the surface area of inner wall of the gas activating means.

### Description of reference numbers

| | | | |
|---|---|---|---|
| 1 | vacuum exhaust system | 1a | pressure control valve |
| 2 | reaction chamber | 3 | shower plate |
| 4 | gas activating means | 5 | gas-mixing unit |
| 6 | raw gas-pipe line | 7 | evaporator |
| 7a | raw material-supply zone | 8 | pipe line |
| S | substrate | | |

### Industrial applicability

According to the present invention, the epitaxial growth of a film is promoted and a ferroelectric thin film having regular orientation and a low leak current density and whose spontaneous polarization is saturated at a low voltage can be prepared by using the oxidation gas of rate of the flow rate such that prescribed the partial pressure of the oxygen is obtained. Moreover, metal atom-containing molecules obtained in the decomposition step of the raw gas which permits the preparation of films having good characteristic properties are introduced into the reaction chamber to use the molecules for the preparation of the ferroelectric thin film. Thus, it becomes possible to prepare the thin film having an improved oxygen defects. For this reason, there can be provided a method for the preparation of a ferroelectric thin film having excellent characteristic properties. Furthermore, by arranging the gas activating means between the gas-mixing unit and the shower plate, there can be provided an apparatus for preparing the thin film having the improved oxide defect. These film-forming method and apparatus are quite useful in the fields of semiconductor element-production.

## Claims

1. A method for preparing an oxide thin film on a substrate, which comprises the steps of admixing a raw gas obtained through the vaporization of a raw material for the oxide thin film, a carrier gas and an oxidation gas in a gas-mixing unit and supplying the resulting gas mixture on a heated substrate placed in a reaction chamber as a chemical vapor phase growth apparatus through a shower plate to thus make the gas mixture react with one another, supplying the gas mixture into the reaction chamber through a gas activating means which is arranged between the gas-mixing unit and the shower plate, which includes a pipe line whose inner wall surface area is 4.8 x 10⁻³ m² to 1.28 x 10⁻¹ m² and which is maintained at such a temperature that in introducing the raw gas into the shower plate the raw gas is vapor phase decomposed into metal atom-containing molecules, which can prepare a film having desired properties; wherein a rate of oxidation gas flow rate is not less than 60 % on the basis of the gas mixture; and
wherein the oxide thin film is an oxide of a paraelectric dielectric material selected from the group consisting of SiO₂, TiO₂, Al₂O₃, Ta₂O₅, MgO, ZrO₂, HfO₂, (Ba, Sr)TiO₂ and SrTiO₃; or an oxide of a ferroelectric material selected from the group consisting of Pb(Zr, Ti)O₃, SrBi₂Ta₂O₉ and B₄Ti₃O₁₂.

2. The method for preparing an oxide thin film as set forth in claim 1, wherein the oxidation gas is a member selected from the group consisting of oxygen, ozone, N₂O and NO₂.

3. The method for preparing an oxide thin film as set forth in any one of claims 1 to 2, wherein the carrier gas used is an inert gas selected from the group consisting of nitrogen, helium, argon, neon and krypton.

4. The method for preparing an oxide thin film as set forth in any one of claims 1 to 3, wherein the substrate used is one prepared from a material selected from the group consisting of Pt, Ir, Rh, Ru, MgO, SrTiO₃, IrO₂, RuO₂, SrRuO₃, and LaNiO₃.

## Patentansprüche

1. Verfahren zur Herstellung eines Oxiddünnfilms auf einem Substrat, enthaltend als Schritte das Vermischen eines durch Verdampfen eines Rohmaterials für den Oxiddünnfilm erhaltenen Rohgases, eines Trägergases und eines Oxidationsgases in einer Gasmischeinheit und Zuführen des resultierenden Gasgemischs durch eine Brauseplatte auf ein in einer Reaktionskammer als chemischer Gasphasenabscheidungsvorrichtung angeordnetes, erhitztes Substrat, um das Gasgemisch so gegenseitig zum Reagieren zu bringen, das Zuführen des Gasgemischs zur Reaktionskammer durch ein zwischen der Gasmischeinheit und der Brauseplatte angeordnetes Gas-Aktivierungsmittel, das eine Rohrleitung umfasst, deren innere Wandoberfläche 4,8 x 10⁻³ m² bis 1,28 x 10⁻¹ m² beträgt und die auf einer solchen Temperatur gehalten wird, dass das Rohgas beim Einleiten des Rohgases in die Brauseplatte in der Gasphase in metallatomhaltige Moleküle aufgespaltet wird, die einen Film mit den gewünschten Eigenschaften bilden können; wobei der Anteil der Durchflussmenge des Oxidationsgases bezogen auf das Gasgemisch nicht weniger als 60 % beträgt; und wobei der Oxiddünnfilm ein Oxid eines aus der Gruppe bestehend aus SiO₂, TiO₂, Al₂O₃, Ta₂O₅, MgO, ZrO₂, HfO₂, (Ba, Sr)TiO₂ und SrTiO₃ ausgewählten paraelektrischen dielektrischen Materials; oder ein Oxid eines aus der Gruppe bestehend aus Pb(Zr, Ti)O₃, SrBi₂Ta₂O₉ und Bi₄Ti₃O₁₂ ausgewählten ferroelektrischen Materials ist.

2. Verfahren zur Herstellung eines Oxiddünnfilms nach Anspruch 1, wobei das Oxidationsgas ein Mitglied aus der Gruppe bestehend aus Sauerstoff, Ozon, N₂O und NO₂ ist.

3. Verfahren zur Herstellung eines Oxiddünnfilms nach einem der Ansprüche 1 bis 2, wobei das verwendete Trägergas ein aus der Gruppe bestehend aus Stickstoff, Helium, Argon, Neon und Krypton ausgewähltes Inertgas ist.

4. Verfahren zur Herstellung eines Oxiddünnfilms nach einem der Ansprüche 1 bis 3, wobei das Substrat ein aus einem aus der Gruppe bestehend aus Pt, Ir, Rh, Ru, MgO, SrTiO₃, IrO₂, RuO₂, SrRuO₃ und LaNiO₃ ausgewählten Material hergestelltes Substrat ist.

## Revendications

1. Procédé de préparation d'un film mince d'oxyde sur un substrat, comprenant les étapes consistant à mélanger un gaz brut obtenu par la vaporisation d'une matière première pour le film mince d'oxyde, un gaz porteur et un gaz oxydant dans une unité de mélange de gaz et à amener par une plaque d'arrosage le mélange de gaz résultant sur un substrat chauffé placé dans une chambre de réaction en tant que dispositif de dépôt chimique en phase vapeur afin de faire réagir ainsi réciproquement le mélange de gaz, à amener le mélange de gaz dans la chambre de réaction par un moyen d'activation des gaz agencé entre l'unité de mélange de gaz et la plaque d'arrosage et comprenant une conduite qui a une superficie de la paroi intérieure de 4,8 x 10⁻³ m² à 1,28 x 10⁻¹ m² et qui est maintenue à une telle température que lorsque le gaz brut est introduit dans la plaque d'arrosage, le gaz brut est décomposé en phase vapeur en molécules contenant des atomes métalliques pouvant former un film aux propriétés souhaitées; où un taux du débit du gaz oxydant n'est pas inférieur à 60 % sur la base du mélange de gaz; et où le film mince d'oxyde est un oxyde d'un matériau paraélectrique diélectrique choisi parmi le groupe comprenant SiO₂, TiO₂, Al₂O₃, Ta₂O₅, MgO, ZrO₂, HfO₂, (Ba, Sr)TiO₂ et SrTiO₃; ou un oxyde d'un matériau ferroélectrique choisi parmi le groupe comprenant Pb(Zr, Ti)O₃, SrBi₂Ta₂O₉ et Bi₄Ti₃O₁₂.

2. Procédé de préparation d'un film mince d'oxyde selon la revendication 1, où le gaz oxydant est un membre choisi parmi le groupe comprenant l'oxygène, l'ozone, N₂O et NO₂.

3. Procédé de préparation d'un film mince d'oxyde selon l'une quelconque des revendications 1 à 2, où le gaz porteur utilisé est un gaz inerte choisi parmi le groupe comprenant l'azote, l'hélium, l'argon, le néon et le krypton.

4. Procédé de préparation d'un film mince d'oxyde selon l'une quelconque des revendications 1 à 3, où le substrat utilisé est un substrat préparé à partir d'un matériau choisi parmi le groupe comprenant Pt, Ir, Rh, Ru, MgO, SrTiO₃, IrO₂, RuO₂, SrRuO₃, et LaNiO_{3.}
